# EUROPEAN PATENT SPECIFICATION

(11) **EP 0 321 065 B1**
(45) Date of publication and mention of the grant of the patent: **28.12.1994**
(21) Application number: 88302843.3
(22) Date of filing: 30.03.1988
(51) Int. Cl.: H01L 21/82, H01L 21/90, H01L 23/48, H01L 29/40

(54) **Method of manufacture of Schottky compound semiconductor devices**
Verfahren zur Herstellung von Schottky-Verbundhalbleiterbauelement
Procédé de fabrication de dispositifs semi-conducteurs composites du type Schottky

(30) Priority: 18.12.1987 JP 318541/87
(43) Date of publication of application: 21.06.1989
(73) Proprietor: The Agency of Industrial Science and Technology, Chiyoda-ku Tokyo-to (JP)
(72) Inventor: Imamura, Yoshinori Central Lab., Kokubunji-Shi Tokyo (JP); Miyazaki, Masaru Central Lab., Kokubunji-Shi Tokyo (JP); Terano, Akihisa Central Lab., Kokubunji-Shi Tokyo (JP); Matsunaga, Nobutoshi Central Lab., Kokubunji-Shi Tokyo (JP); Yanazawa, Hiroshi Central Lab., Kokubunji-Shi Tokyo (JP)
(74) Representative: Paget, Hugh Charles Edward

(56) References cited:
- DE-A- 3 516 222
- US-A- 4 631 806
- GaAs IC SYMPOSIUM TECHNICAL DIGEST 1987 13-16 October 1987, pages 45-48, Portland, Oregon, US; K. ITO et al.: "A Self-Aligned Planar GaAs MESFETTechnology for MMICs"
- PATENT ABSTRACTS OF JAPAN vol. 9, no. 189 (E-333)(1912), 6 August 1985; & JP-A-6057980

## Description

The present invention relates to a semiconductor integrated circuit device and more particularly to a method of manufacture of semiconductor devices suitable for high density integration in GaAs integrated circuit devices.

In order to connect the Schottky junction electrodes with ohmic electrodes formed in the active layer in the conventional semiconductor device, it is known to form an interlayer insulation film after the formation of the Schottky and ohmic electrodes, and then provide contact holes at specified places in the interlayer insulation film for metal wiring connection through these holes as described in Japanese Laid-Open Patent Specification Nos. 60-3409 and 60-57980.

In US-A-4 631 806 interconnects between Schottky and ohmic electrodes in silicon are also disclosed.

However, the conventional technology referred to above does not take into account the increase in element area by contact hole formation. As a result a problem arises because the chip size cannot be reduced when forming a GaAs IC with a high degree of integration density.

It is an object of the present invention to provide the compound semiconductor device with a small element size by directly connecting the Schottky electrodes and ohmic electrodes formed on the semiconductor substrate at a high yield ratio, using neither the third wiring metal other than those electrodes nor contact or through holes.

The above object can be achieved by directly connecting ohmic electrodes on Schottky electrodes.

According to the present invention there is provided a method of manufacturing a compound semiconductor device including the steps of:
a method of manufacture of compound semiconductor devices including the steps of: forming an N or P type active region in a compound semiconductor substrate: forming Schottky junction electrodes made of refractory metal on the semiconductor substrate, at least one of the electrodes being formed over and in the middle of the active region; forming insulating side wall spacers on the edges of the Schottky electrodes, said side wall spacers being formed from a first deposited insulating layer; carrying out an implanting step using a photoresist mask and where the electrodes together with their side wall spacers also act as a mask to form high density activated regions in the substrate; depositing a second insulating layer on the surface of the substrate and of the electrodes; masking the second insulating layer with a photoresist layer wherein two openings have been defined; removing the second insulating layer through said mask by a combination of anistropic and isotropic etching so as to form a first continuous opening exposing predetermined portions of the Schottky junction electrodes and of the high density activated regions, and a second opening exposing only another portion of the high density activated regions; depositing an ohmic electrode material layer on the exposed substrate surface, on the exposed Schottky electrodes and on the photoresist mask; lifting off part of the ohmic electrode material layer by removing the photoresist mask; and alloying the ohmic electrode material layer to form an ohmic junction between the said ohmic electrode material and the high density activated regions.

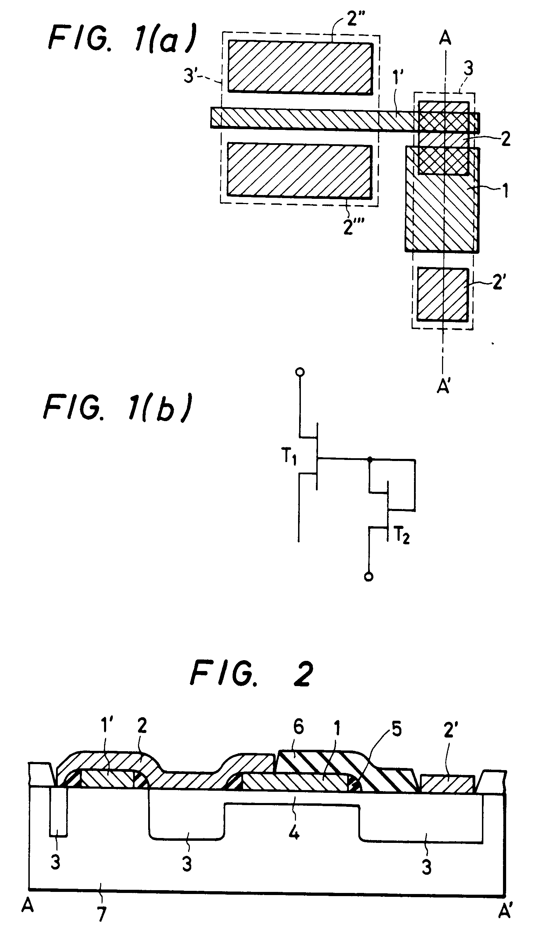

The present invention will now be explained in greater detail by way of example with reference to the accompanying drawings, wherein:-
Fig. 1(a) is a plan view of a semiconductor device manufactured in accordance with the method of the present invention;
Fig. 1(b) is a circuit diagram of the semiconductor device shown in Fig. 1(a);
Fig. 2 is a sectional view on the line A-A of Fig. 1(a); and
Figs. 3(a) to 3(g) show various stages in the manufacture of the semiconductor device.

Referring to the drawings, the gate electrode 1′ of a first MESFET (metal semiconductor field effect transistor) T1 having the Schottky junction gate electrode and source electrode 2 (ohmic electrodes), and the gate electrode 1 of a second MESFET T2 are directly connected by ohmic electrode 2 without the aid of contact holes and wiring layer. The area for contact hole formation is unnecessary to enable the chip area to be reduced.

Ohmic electrode 2 is in ohmic contact with n-type high-density layer (n⁺ layer) 3 having an active portion 4 of MESFET T2 to serve as the source electrode and is also directly connected to gate metal 1 and 1′ of MESFET T1 and T2. As a result, contact holes and the connecting wiring layer are unnecessary to reduce the element area considerably. Side wall 5 consisting of an insulating film is formed in tapered form beside the gate metal to prevent disconnection at the wiring portion where ohmic electrode 2 rides over the gate metal. The high-density layer 3 is formed on a semiconductor substrate 7.

Surface protecting film 6 consists of a material which allows selective isotropic etching except for side wall 5 so that the side wall 5 remains unetched when suface protecting film 6 is removed by etching at the portion where ohmic electrode 2 is formed.

Since this invention enables the Schottky joint metals and ohmic electrodes formed on the compound semiconductor device to be connected directly at high yield without using the contact holes and wiring metal layer, the element area can be reduced. The element area at the connecting portion can be reduced to less than one half as compared with the case using the contact holes and wiring metal. Furthermore, the side wall formed for the Schottky joint metal in this invention makes the ohmic electrode overriding the Schottky junction metal in tapered shape, and enables high yield connection without the fear of disconnection.

Embodiments of the present invention will now be explained in greater detail for the base where GaAs is used as the semiconductor substrate. However, the method of the present invention is applicable to other III-V group compound semiconductors such as InP, InGaAs, AlGaAs, InAlAs and InGaAsp.

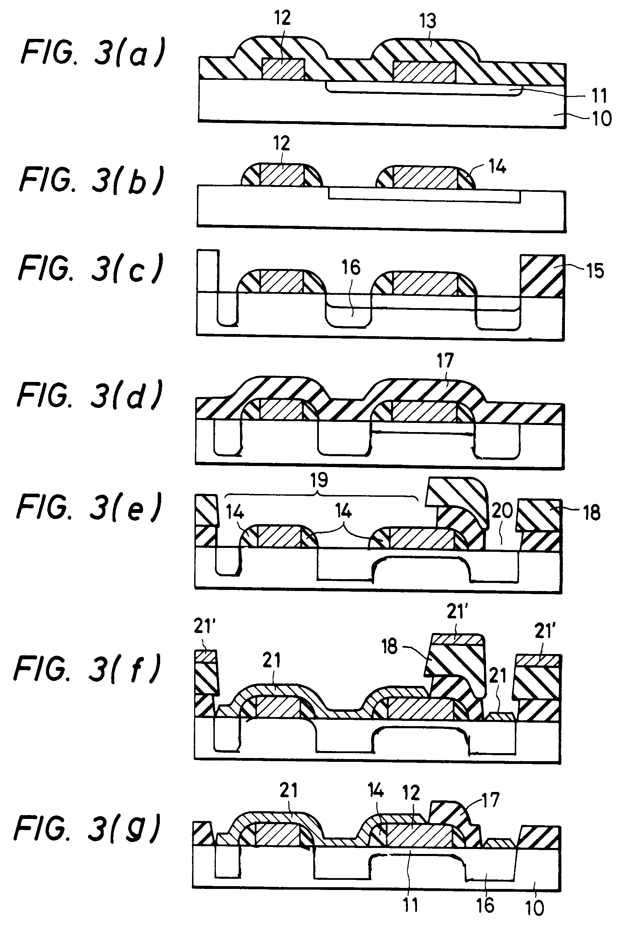

The first embodiment will now be described with reference to Figs. 3(a) to 3(g). In Fig. 3(a), side wall material 13 is deposited after forming an active region 11 within and a Schottky junction metal 12 on a semi-insulating GaAs substrate 10.

The active region 11 is formed by annealing at 800°C for 20 minutes in hydrogen atmosphere with the Si0₂ film as the cap film after implanting 2 x 10¹² pcs/cm² of Si⁺ ions to the specified place at an accelerating voltage of 50KV by ion implantation process. Schottky junction metal 12 is formed by dry etching using flouride gas (NF₃, CF₄, SF₆, etc.) with the photo resist as the mask after depositing refractory metal, tungsten silicide, to a film thickness of 300 nm by a sputtering process. As an insulating film 13, a material, having selectivity as against the etching of surface protecting film 17 in Figure 3(d), such as Si0xNy (silicone exynitride) having refractive index n = 1.75 for example is suitable (thickness 300 nm). Si0xNy can be formed by the ordinary plasma CVD (plasma excited chemical vapour deposition) method using monosilane SiH₄, nitrogen N₂ and nitrous oxide N₂0 as reaction gases. The Si0xNy film with a refractive index of 1.75 can be formed by ordinary parallel plate plasma excited chemical vapour desposition) by setting the reaction gas mixing ratio to be SiH₄ : N₂0 = 15 : 36 : 20, total pressure to 5 Pa and discharge power to 100 W (electrode diameter: 40 cm).

In Figure 3(b), a side wall 14 is formed by etching the above Si0xNy film by the anisotropic dry etching process using CHF₃ + CF₄ gas. In Figure 3(c), a high density activated region 16 is formed by the ion implantation process with a photo resist 15 as the mask. 3 x 10 ¹³ pca/cm² of Si⁺ ions are implanted with the implanting energy at 150 WV. In Figure 3(d), silicon dioxide (Si0₂) is deposited in a film thickness of 300 nm by the chemical vapour deposition process under atmospheric pressure. With this film as surface protecting film 17, the high density region is activated by annealing at 80°C in hydrogen atmosphere for 15 minutes to form the source-drain area. In Figure 3(e), an opening 19 is provided in the above surface protecting film 17 using (18) photo resist as the mask. At least one opening 19 is provided which continuously connects the upper part of the specified portion of the high density activated region 16 and Schottky junction electrodes. In Fig. 3(e), another opening 20 covers only the upper part of the high density activated region 16 while the opening 19 continuously covers the upper sides of high density activated region 16 and a specified portion of Schottky electrode 12. Openings 19 and 20 are produced by a combination of anisotropic dry etching and isotropic wet etching. At first, surface protecting film 17 consisting of silicon dioxide (Si0₂) is removed by anisotropic etching under the dry etching conditions at the CHF₃ and C₂F₆ gas flow rates of 100 cc/min and 60 cc/min, respectively, and a high frequency discharge power of 300 W (electrode diameter: 20 cm). It is desirable to keep the over etch amount of dry etching at around 200 to 1000 Å (10 Å = 1 nm) to leave side wall 14. Next, isotropic etching of surface protecting film 17 is carried out using buffer hydrofluoric acid (water : hydrofluoric acid : ammonium fluoride = 1 : 1 : 12) for side etching of 500 to 3000 Å, preferably in a range between 500 Å and 1500 Å. The purpose of this side etching is for lifting off ohmic electrode 21 with good precision as shown in Fig. 3 (g) . The etching speed of surface protecting 17 by the above buffer hydrofluoric acid is approximately 2500 Å/min. On the other hand, the etching speed of side wall 14 consisting of Si0xNy with refractive index of 1.75 by the above buffer hydrofluoric acid is approximately 250 Å/min which is one digit less than the etching speed of above surface protecting film 17. Therefore when surface protecting film 17 is applied with side etching to 500 to 3000 Å by the buffer hydrofluoric acid, side wall 14 remains almost unetched.

Next the process shown in Fig. 3(f) starts. Here, ohmic electrodes 21 and 21′ consisting of AuGe (600 Å)/Ni (100 Å)/Au (1500 Å) are vapour-deposited on the whole surface of the wafer provided with openings in the process shown in Fig. 3(e). Ohmic electrode 21 deposited on openings 19 and 20 and ohmic electrode 12 deposited on photo resist 18 are perfectly disconnected by the effect of side etching for the openings of surface protecting film 17 formed in Fig. 3(e). The wafer vapour-deposited with the above ohmic electrodes is immersed in resist removing agent to remove unnecessary ohmic electrodes 21′ by lift off. Then 3-minute alloying at 400°C in nitrogen atmosphere is conducted for 3 minutes to establish ohmic contact between the ohmic electrodes and high density actived layer. Fig. 3(g) shows the result.

By the processes described above, the Schottky junction electrodes, the ohmic electrodes and the high density activated region formed in the GaAs substrate are directly connected without using conventional contact holes and wiring metal. In this method, the side walls 14 which are located beside the Schottky joint metal serve as spacers at the positions where the ohmic electrode rides over the Schottky joint metal, in order to prevent disconnection of the ohmic electrode. This embodiment shows that the ohmic electrodes, high density activated layer and Schottky joint metal are connected with good yield without requiring the conventional contact holes and wiring metal, reducing the required element area.

A second embodiment will now be described. The process flow in this embodiment is the same as the one shown in Fig. 3 explained for embodiment 1 except that side wall 14 formed beside the Schottky junction metal is made of boron nitride (BN). The boron nitride film is formed either by the sputtering process using ordinary Ar discharge or by the plasma chemical vapour deposition process using B₂H₆ gas and N₂ or NH₃ gas. The anisotropic etching for BN film side wall formation in Figure 3(b) uses anisotropic dry etching under the conditions of CF₄ gas flow rate at 100 cc/min, pressure at 5 Pa and high frequency power at 100 W (electrode diameter: 20 cm). The BN film formed either by the sputtering process or plasma chemical vapour deposition process described above involves extremely slow etching speed by the buffer hydrofluoric acid at 10 Å/min or less, the side etching shown in Fig. 3(e) is easily performed without etching side wall 14 formed by the BN film when silicon dioxide (Si0₂), PSG glass, BPSG glass or Si0xNy (silicon oxynitride) is used as surface protecting film 17. Since side wall 14 remains almost unetched in this embodiment, the connection between ohmic electrodes and Schottky junction metals is formed at a high yield without disconnection at the override portion.

## Claims

1. A method of manufacture of compound semiconductor devices including the steps of: forming an N or P type active region (11) in a compound semiconductor substrate (10); forming Schottky junction electrodes (12) made of refractory metal on the semiconductor substrate (10), at least one of the electrodes (12) being formed over and in the middle of the active region (11); forming insulating side wall spacers (14) on the edges of the Schottky electrodes (12), said side wall spacers being formed from a first deposited insulating layer (13); carrying out an implanting step using a photoresist mask (15) and where the electrodes (12) together with their side wall spacers (14) also act as a mask to form high density activated regions (16) in the substrate (10); depositing a second insulating layer (17) on the surface of the substrate (10) and of the electrodes (12); masking the second insulating layer (17) with a photoresist layer (18) wherein two openings have been defined; removing said second insulating layer (17) through said mask by a combination of anisotropic and isotropic etching so as to form a first continuous opening (19) exposing predetermined portions of the Schottky junction electrodes (12) and of the high density activated regions (16), and a second opening (20) exposing only another portion of the high density activated regions (16); depositing an ohmic electrode material layer (21) on the exposed substrate surface, on the exposed Schottky electrodes (12) and on the photoresist mask (18); lifting off part of the ohmic electrode material layer (21) by removing the photoresist mask (18); and alloying the ohmic electrode material layer (21) to form an ohmic junction between the said ohmic electrode material and the high density activated regions (16).

2. A method of manufacture of compound semiconductor devices according to claim 1, wherein the second insulating layer (17) consists of at least one material allowing selective isotropic etching with reference to the first insulating layer (13).

3. A method of manufacture of compound semiconductor devices according to claim 1, wherein the first insulating layer (13) consists of at least one of silicon nitride or silicon oxynitride and the second insulating layer (17) consists of at least one selected from the group consisting of silicon dioxide, PSG glass and BPSH glass.

4. A method of manufacture of compound semiconductor devices according to claim 1, wherein the first insulating layer (13) consists of boron nitride and the second insulating layer (17) consists of at least one selected from the group consisting of PSG, BPSG glass, silicon oxynitride and silicon dioxide.

5. A method of manufacture of compound semiconductor devices according to claim 1, wherein the first insulating layer (13) consists of at least one selected from the group consisting of silicon dioxide, silicon nitride, silicon oxynitride, boron nitride, PSG glass and BPSG glass, and the second insulating layer (17) consists of aluminium nitride.

## Patentansprüche

1. Verfahren zur Herstellung von Verbundhalbleiterbauelementen umfassend die folgenden Schritte: Bilden eines Aktivbereichs (11) des N- oder P-Typs in einem Verbundhalbleitersubstrat (10); das Bilden von Schottky-Verbindungselektroden (12) aus hochschmelzendem Metall auf dem Halbleitersubstrat (10), wobei zumindest eine der Elektroden (12) über dem Aktivbereich (11) und in der Mitte desselben geformt wird; das Formen von isolierenden Seitenwandabstandhaltern (14) an den Kanten der Schottky-Elektroden (12), wobei die genannten Seitenwandabstandhalter aus einer ersten aufgetragenen isolierenden Schicht (13) gebildet werden; das Durchführen eines Implantierungsschrittes unter Verwendung einer lichtunempfindlichen Maske (15), und worin die Elektroden (12) gemeinsam mit ihren Seitenwandabstandhaltern (14) auch als Maske wirken, um aktivierte Bereiche (16) hoher Dichte im Substrat (10) zu bilden; das Auftragen einer zweiten isolierenden Schicht (17) auf der Oberfäche des Substrats (10) und der Elektroden (12); das Maskieren der zweiten isolierenden Schicht (17) mit einer lichtunempfindlichen Schicht (18), worin zwei Öffnungen definiert wurden; das Entfernen der genannten zweiten isolierenden Schicht (17) durch die genannte Maske durch eine Kombination von anisotropischem und isotropischem Ätzen, um eine erste kontinuierliche Öffnung (19), die vorbestimmte Abschnitte der Schottky-Verbindungselektroden (12) und der aktivierten Bereiche (16) hoher Dichte freilegt und eine zweite Öffnung (20) zu bilden, die nur einen anderen Abschnitt der aktivierten Bereiche (16) hoher Dichte freilegt; das Auftragen einer ohmschen Elektrodenmaterialschicht (21) auf der freigelegten Substratfläche, den freigelegten Schottky-Elektroden (12) und der lichtunempfindlichen Maske (18); das Abheben eines Teils der ohmschen Elektrodenmaterialschicht (21) durch Entfernen der lichtunempfindlichen Maske; und das Legieren der ohmschen Elektrodenmaterialschicht (21) zur Bildung einer ohmschen Verbindung zwischen dem genannten ohmschen Elektrodenmaterial und den aktivierten Bereichen (16) hoher Dichte.

2. Verfahren zur Herstellung von Verbundhalbleiterbauelementen nach Anspruch 1, worin die zweite isolierende Schicht (17) aus zumindest einem Material besteht, das selektives isotropisches Ätzen in bezug auf die erste isolierende Schicht (13) erlaubt.

3. Verfahren zur Herstellung von Verbundhalbleiterbauelementen nach Anspruch 1, worin die erste isolierende Schicht (13) aus zumindest einem von Siliziumnitrid oder Siliziumoxynitrid besteht und die zweite isolierende Schicht (17) aus zumindest einer Substanz besteht, die aus der Gruppe bestehend aus Siliziumdioxid, PSG-Glas und BPSH-Glas ausgewählt ist.

4. Verfahren zur Herstellung von Verbundhalbleiterbauelementen nach Anspruch 1, worin die erste isolierende Schicht (13) aus Bornitrid besteht und die zweite isolierende Schicht (17) aus zumindest einer Substanz besteht, die aus der Gruppe bestehend aus PSG, BPSG-Glas, Siliziumoxynitrid und Siliziumdioxid ausgewählt ist.

5. Verfahren zur Herstellung von Verbundhalbleiterbauelementen nach Anspruch 1, worin die erste isolierende Schicht (13) aus zumindest einer Substanz besteht, die aus der Gruppe bestehend aus Siliziumdioxid, Siliziumnitrid, Siliziumoxynitrid, Bornitrid, PSG-Glas und BPSG-Glas ausgewählt ist, und die zweite isolierende Schicht (17) aus Aluminiumnitrid besteht.

## Revendications

1. Procédé de fabrication de dispositifs semiconducteurs composites, comprenant les opérations de : former une région active (11) du type N ou P dans un substrat semiconducteur composé ou composite (10); former les électrodes de jonction Schottky (12) réalisées en un métal réfractaire sur le substrat semiconducteur (10), au moins l'une des électrodes (12) étant formées sur et au centre de la région active (11); former des éléments d'écartement de paroi latérale isolante (14) sur les bords des électrodes Schottky (12), lesdits éléments d'écartement de paroi latérale étant formés par une première couche isolante déposée (13); exécuter une opération d'implantation utilisant un masque de photorésist (15) et où les électrodes (12), ensemble avec leurs éléments d'écartement de paroi latérale (14), agissent comme un masque pour former des régions activées à haute densité (16) dans le substrat (10); déposer une seconde couche isolante (17) sur la surface de substrat (10) et les électrodes (12); masquer la seconde couche isolante (17) par une couche de photorésist (18) dans laquelle deux ouvertures ont été définies; enlever ladite seconde couche isolante (17) à travers ledit masque par une combinaison d'une attaque chimique anisotrope et isotrope de façon à former une première ouverture continue (19) exposant des portions prédéterminées des électrodes de jonction Schottky (12) et des régions activées à haute densité (16), et une seconde ouverture (20) exposant seulement une autre portion des régions activées à haute densité (16); déposer une couche de matière d'électrode ohmique (21) sur la surface de substrat exposée, sur les électrodes Schottky exposées (12) et sur le masque de photorésist (18) ; arracher une partie de la couche de matière électrode ohmique (21) en enlevant le masque de photorésist (18); et allier la couche de matière d'électrodes ohmique (21) pour former une jonction ohmique entre ladite matière d'électrode ohmique et les régions activées à haute densité (16).

2. Procédé de fabrication de dispositifs semiconducteurs composés selon la revendication 1, selon lequel la seconde couche isolante (17) est constituée d'au moins un matériel permettant une attaque chimique isotrope sélective par rapport à la première couche isolante (13).

3. Procédé de fabrication de dispositifs semiconducteurs composés ou composites selon la revendication 1, dans lesquels la première couche isolante (13) est formée par au moins un nitrure de silicium ou un oxynitrure de silicium et la seconde couche isolante (17) est formée par au moins un élément choisi dans le groupe formé par du dioxyde de silicium, du verre de PSG et du verre de BPSH.

4. Procédé de fabrication de dispositifs semiconducteurs composites selon la revendication 1, dans lequel la première couche isolante (13) est formée par du nitrure de bore et la seconde couche isolante (17) est formée par au moins un des éléments choisis dans le groupe consistant de PSG, de verre de BPSG, d'oxynitrure de silicium et de dioxyde de silicium.

5. Procédé de fabrication de dispositifs semiconducteurs composés selon la revendication 1, dans lequel la première couche isolante (13) est formée par au moins un élément choisi dans le groupe constitué de dioxyde de silicium, de nitrure de silicium, d'oxynitrure de silicium, de nitrure de bore, du verre PSG et du verre de BPSTG et la seconde couche isolante (17) est constituée de nitrure d'aluminium.
